(19) Europäisches Patentamt
European Patent Office
Office européen des brevets

(11) **EP 3 812 050 A1**

(12) **EUROPEAN PATENT APPLICATION**
published in accordance with Art. 153(4) EPC

(43) Date of publication:
**28.04.2021 Bulletin 2021/17**

(21) Application number: **19824864.3**

(22) Date of filing: **02.04.2019**

(51) Int Cl.:
**B05D 3/02** (2006.01)    **B05C 9/14** (2006.01)
**B41F 23/04** (2006.01)    **B41M 7/00** (2006.01)
**F26B 3/30** (2006.01)    **F26B 13/10** (2006.01)
**F26B 23/04** (2006.01)    **H01L 51/50** (2006.01)
**H05B 33/10** (2006.01)

(86) International application number:
**PCT/JP2019/014664**

(87) International publication number:
**WO 2020/003678 (02.01.2020 Gazette 2020/01)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(30) Priority: **25.06.2018 JP 2018119854**

(71) Applicant: **SUMITOMO CHEMICAL COMPANY LIMITED**
**Chuo-ku**
**Tokyo 104-8260 (JP)**

(72) Inventors:
• **SHIMOGAWARA, Masaya**
  **Niihama-shi, Ehime 792-0015 (JP)**
• **YOSHIOKA, Hidemi**
  **Niihama-shi, Ehime 792-0015 (JP)**

(74) Representative: **J A Kemp LLP**
  **14 South Square**
  **Gray's Inn**
  **London WC1R 5JJ (GB)**

(54) **MANUFACTURING METHOD FOR FUNCTIONAL MEMBRANE, DRYING DEVICE, AND MANUFACTURING DEVICE FOR FUNCTIONAL MEMBRANE**

(57)    A manufacturing method for a functional film provided on an upper surface of a long substrate, includes coating an ink containing a material of the functional film on the upper surface of the substrate to form a coating film, and drying the coating film while conveying the substrate. The drying process includes a first process in which the substrate is conveyed for a first distance and a temperature of the substrate is raised from a first temperature to a second temperature during conveyance. In the first process, assuming that the first distance is $d_1$ (m), the first temperature is $T_1$ (°C), and the second temperature is $T_2$ (°C), the following expression is satisfied:

$$(T_2 - T_1)/d_1 \geq 10 \quad (1a).$$

A maximum value of an instantaneous temperature change rate of the substrate is 5°C/sec or less.

FIG.1

**Description**

TECHNICAL FIELD

The present invention relates to a manufacturing method for a functional film, a drying device, and a manufacturing device for the functional film.

BACKGROUND ART

The organic EL element has a functional film on the surface of the substrate. A film such as a functional film is formed by applying an ink containing a film material on a substrate and then performing a drying process in a drying furnace. JP-A-2002-340479 (Patent Document 1) describes that wind prints can be prevented from occurring on the surface quality of the film by controlling a wind speed of hot air sent into a drying furnace.

PRIOR ART DOCUMENT

PATENT DOCUMENT

Patent Document 1: JP-A-2002-340479

SUMMARY OF THE INVENTION

PROBLEMS TO BE SOLVED BY THE INVENTION

An object of the invention is to provide a manufacturing method for a functional film, a drying device, and a manufacturing device for a functional film, which can suppress the occurrence of streak-like unevenness on the surface of the functional film.

MEANS FOR SOLVING THE PROBLEMS

The invention provides the following [1] to [16].

[1] A manufacturing method for a functional film provided on an upper surface of a long substrate, including:

coating an ink containing a material of the functional film on the upper surface of the substrate to form a coating film; and
drying the coating film while conveying the substrate,
in which the drying process includes a first process in which the substrate is conveyed for a first distance and a temperature of the substrate is raised from a first temperature to a second temperature during conveyance,
in the first process, assuming that the first distance is $d_1$ (m), the first temperature is $T_1$ (°C), and the second temperature is $T_2$ (°C), the following expression is satisfied:

$$(T_2 - T_1)/d_1 \geq 10 \quad (1a),$$

and
a maximum value of an instantaneous temperature change rate of the substrate is 5°C/sec or less.

[2] The manufacturing method for a functional film according to [1], in which
the drying process includes a second process, after the first process, in which the substrate is conveyed by a second distance, and the temperature of the substrate is maintained in a range near the second temperature, and
the range near the second temperature is $T_2 \pm 5$°C.
[3] The manufacturing method for a functional film according to [1] or [2], in which, in the first process, two or more conveyance rolls are sequentially brought into contact with a lower surface of the substrate to convey the substrate.
[4] The manufacturing method for a functional film according to [3], in which at least one of the conveyance rolls is a hollow roll or a surface stepped roll.
[5] The manufacturing method for a functional film according to [3] or [4], in which at least one of the conveyance rolls has an average heat capacity of 110 J/K or less per width.

[6] The manufacturing method for a functional film according to any one of [1] to [5], in which, in the coating, an ink is applied by an inkjet printing method.

[7] The manufacturing method for a functional film according to any one of [1] to [6], in which, in the first process, the substrate is heated by irradiation with infrared rays.

[8] The manufacturing method for a coating film according to any one of [1] to [7], in which the functional film is an element of an organic EL element.

[9] A drying device for drying a coating film formed on an upper surface of a long substrate, including a first processing unit that conveys the substrate for a first distance and raises a temperature of the substrate from a first temperature to a second temperature during conveyance,

in which, in the first processing unit, assuming that the first distance is $d_1$ (m), the first temperature is $T_1$ (°C), and the second temperature is $T_2$ (°C), the following expression is satisfied:

$$(T_2-T_1)/d_1 \geq 10 \qquad (1a),$$

and

a maximum value of an instantaneous temperature change rate of 5°C/sec or less.

[10] The drying device according to [9], further including a second processing unit, at a stage later than the first processing unit, that conveys the substrate for a second distance and maintains the temperature of the substrate in a range near the second temperature during conveyance,

in which the range near the second temperature is $T_2 \pm 5$°C.

[11] The drying device according to [9] or [10], in which the first processing unit brings two or more conveyance rolls sequentially into contact with a lower surface of the substrate to convey the substrate.

[12] The drying device according to [11], in which at least one of the conveyance rolls is a hollow roll or a surface stepped roll.

[13] The drying device according to [11] or [12], in which at least one of the conveyance rolls has an average heat capacity of 110 J/K or less per width.

[14] The drying device according to any one of [9] to [13], in which the first processing unit heats the substrate by irradiation with infrared rays.

[15] A manufacturing device for a functional film on an upper surface of a long substrate, including the drying device according to any one of [9] to [14].

[16] The manufacturing device according to [15], in which the functional film is an element of an organic EL element.

EFFECT OF THE INVENTION

According to a manufacturing method of the invention, it is possible to suppress the occurrence of streak-like unevenness on the surface of a functional film.

BRIEF DESCRIPTION OF THE DRAWINGS

Fig. 1 is a cross-sectional view schematically illustrating a drying device according to an embodiment of the invention.
Fig. 2A is a cross-sectional view schematically illustrating an example of a surface stepped roll.
Fig. 2B is a cross-sectional view schematically illustrating an example of the surface stepped roll.
Fig. 3 is a cross-sectional view schematically illustrating the configuration of an organic EL element according to a first embodiment.
Fig. 4 is a cross-sectional view schematically illustrating a light-emitting layer forming process in the first embodiment.
Fig. 5A is a graph plotting the temperature in a first process of a first experimental example.
Fig. 5B is a graph plotting the instantaneous temperature change rate in the first process of the first experimental example.
Fig. 6A is a graph plotting the temperature in a first process of a second experimental example.
Fig. 6B is a graph plotting the instantaneous temperature change rate in the first process of the second experimental example.
Fig. 7A is a graph plotting the temperature in a first process of a third experimental example.
Fig. 7B is a graph plotting the instantaneous temperature change rate in the first process of the third experimental example.

Fig. 8A is a photoluminescence picture of the functional film of the first experimental example.

Fig. 8B is a photoluminescence picture of the functional film of the third experimental example.

MODE FOR CARRYING OUT THE INVENTION

[Manufacturing method for functional film]

The invention relates to a manufacturing method for a functional film provided on the upper surface of a long substrate, and includes a coating process of applying an ink containing a material for the functional film to the upper surface of the substrate to form a coating film, and a drying process of drying the coating film while transporting the substrate. The coating film before being subjected to the ink and drying processes contains a material for the functional film and a solvent for dispersing or dissolving it.

<Drying process>

The drying process includes a first process. The drying process preferably includes a second process after the first process. The first process is a temperature raising process in which the substrate is conveyed for a first distance and the temperature of the substrate is raised from a first temperature to a second temperature during that time. In the first process, assuming that the first distance is $d_1$ (m), the first temperature is $T_1$ (°C), and the second temperature is $T_2$ (°C), the following Expression (1a) is satisfied:

$$(T_2 - T_1)/d_1 \geq 10 \quad (1a).$$

The second process is a constant temperature process in which the substrate is conveyed for a second distance and the temperature of the substrate during that period is maintained in a range near the second temperature. The range near the second temperature is preferably $T_2 \pm 5$°C, and more preferably $T_2 \pm 2$°C.

The first temperature $T_1$ and the second temperature $T_2$ are values measured as follows. The temperature at an arbitrary position on the substrate is measured at 0.1 second intervals from the start point to the end point of the first process, that is, during the conveyance for the first distance $d_1$. When the measured temperature after x seconds since the start point is $T_x$ (°C), a minimum value of $T_x$ is set to the first temperature $T_1$, and the maximum value of $T_x$ is set to the second temperature $T_2$. Arbitrary positions for measuring $T_x$ are two different positions where the position in the width direction is the same distance from the end (hereinafter, also referred to as "position A1" and "position A2"). The minimum value in the temperatures measured at the two positions is set to the first temperature $T_1$, and the maximum value is set to the second temperature $T_2$. Normally, the first temperature $T_1$ substantially coincides with the temperature at the start point of the first process, and the second temperature $T_2$ substantially coincides with the temperature at the end point of the first process. In the first process, it is preferable that the target reaching temperature is set in advance, and the second temperature $T_2$ and the target reaching temperature are substantially the same. The target reaching temperature is preferably determined according to the boiling point of the solvent contained in the coating film.

The measuring method for the temperatures at the positions A1 and A2 of the substrate is not particularly limited as long as it is a thermometer capable of measuring at 0.1 second intervals, and may be a contact type or a non-contact type. Examples of such a thermometer include a resistance temperature detector and a thermoelectric pair that can be attached to the positions A1 and A2 of the substrate.

In the first process and the second process, the substrate is conveyed at a predetermined conveyance speed. The removal rate of the solvent contained in the coating film after the first process and the second process is preferably 80% or more, more preferably 90% or more, and still more preferably 99% or more. It is preferable that the first distance $d_1$ is appropriately determined based on the conveyance speed, the temperature responsiveness of the substrate, and the like so that the second temperature $T_2$ and the target reaching temperature substantially coincide with each other. The second distance $d_2$ is preferably determined as appropriate so as to achieve the target solvent removal rate based on the conveyance speed, the thickness of the coating film, the solvent content of the coating film, and the like.

The conveyance speed of the substrate in the first process and the second process is, for example, 0.5 to 5 m/min, and preferably 1 to 3 m/min. The first distance $d_1$ is, for example, a distance within a range of 1 m or more and 5 m or less. The second distance $d_2$ is, for example, a distance within a range of 2 m or more and 10 m or less.

In the first process, the maximum value of the instantaneous temperature change rate is 5°C/sec or less. The instantaneous temperature change rate is calculated every 0.1 seconds from the start point to the end point of the first process. Assuming $R_x$ (°C/sec) for the instantaneous temperature change rate after x seconds (0.6 seconds, 0.7 seconds, 0.8 seconds,...) since the start point (0 seconds), and $T_x$ for the temperature of the position A1 or the position A2 of the substrate after x seconds since the start point, the instantaneous temperature change rate $R_x$ is a slope obtained by performing simple regression analysis by the least squares method so as to be approximated by the linear equation from the temperature of 10 points every 0.1 seconds from x - 0.5 seconds to x + 0.4 seconds, that is, the temperatures of 10 points, $T_{x-0.5}$, $T_{x-0.4}$, $T_{x-0.3}$, $T_{x-0.2}$, $T_{x-0.1}$, $T_x$, $T_{x+0.1}$, $T_{x+0.2}$, $T_{x+0.3}$, and $T_{x+0.4}$.

In the first process, when the maximum value of the instantaneous temperature change rate $R_x$ at the position A1 and the position A2 is 5°C/sec or less, the streak-like unevenness generated in the functional film can be suppressed. In the first process, the maximum value of the instantaneous temperature change rate $R_x$ is preferably 4°C/sec or less from the viewpoint of further suppressing streak-like unevenness.

The present inventors have predicted that a momentarily large temperature change may be caused in the temperature raising process such as the first process, which tends to cause streak-like unevenness in the direction orthogonal to the conveyance direction in the functional film, and have achieved the invention. Further, predicting that a large temperature change is likely to occur momentarily at the moment of contact with the conveyance roll or before and after the contact in the state of conveying the substrate by the conveyance roll, and particularly that a large temperature change is likely to occur momentarily at the moment of contact with the conveyance roll or before and after the contact at a time close to the start point of the first process, the inventors have reached a specific embodiment of the invention.

The first process preferably satisfy Expression (1b) from the viewpoint of shortening the time.

$$(T_2 - T_1)/d_1 \geq 20 \qquad (1b)$$

In the first process, from the viewpoint that it is easy to construct a process section in which the maximum value of the instantaneous temperature change rate $R_x$ satisfies 5°C/sec or less, Expression (1c) is preferably satisfied.

$$(T_2 - T_1)/d_1 \leq 50 \qquad (1c)$$

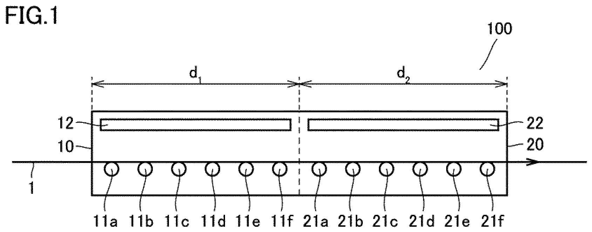

Fig. 1 is a cross-sectional view schematically illustrating a drying device that performs a drying process. A drying device 100 includes a first processing unit 10 and a second processing unit 20. A substrate 1 is conveyed so as to pass through the first processing unit 10 and the second processing unit 20 sequentially. The first process is performed in the first processing unit 10, and the second process is performed in the second processing unit 20.

Six conveyance rolls 11a to 11f and a heating unit 12 are provided in the first processing unit 10. In the first processing unit 10, the substrate 1 is conveyed by the first distance $d_1$ by sequentially contacting the six conveyance rolls 11a to 11f with the lower surface of the substrate 1. During that time, the substrate 1 is heated by the heating unit 12 to raise the temperature of the substrate 1 from the first temperature to the second temperature.

Six conveyance rolls 21a to 21f and a heating unit 22 are provided in the second processing unit 20. In the second processing unit 20, the substrate 1 is conveyed by the second distance $d_2$ by sequentially contacting the six conveyance rolls 21a to 21f with the lower surface of the substrate 1. During that time, the substrate 1 is heated by the heating unit 22 to keep the temperature of the substrate 1 within a range near the second temperature.

The number of conveyance rolls in the first processing unit 10 and the second processing unit 20 is not limited to six, and if there are two or more conveyance rolls, they can be appropriately designed according to the conveyance distance. The number of conveyance rolls in the first processing unit 10 and the second processing unit 20 is, for example, 3 to 10.

Each conveyance roll is cylindrical, and is not limited as long as it has a configuration in which the substrate 1 can be conveyed by rotating the substrate 1 while contacting the surface. The central portion of the conveyance roll may be a hollow roll that is hollow or a solid roll that is not hollow. The conveyance roll may be a smooth surface smoothing roll which has the smooth surface and is in contact with the entire lower surface of the substrate 1, or a surface stepped roll that is stepped and is in contact with a part of the lower surface of the substrate 1. The material of the conveyance roll is not particularly limited, and examples of the surface material thereof include resin, ceramic, metal, and wood. The diameter of the conveyance roll is not particularly limited, and is, for example, 30 mm to 100 mm. The conveyance rolls 11a to 11f in the first processing unit 10 and the conveyance rolls 21a to 21f in the second processing unit 20 do not necessarily have to be the same, and may be individually selected as appropriate.

Even if the heating unit 12 in the first processing unit 10 heats the substrate 1 by irradiating energy rays and its radiant heat, the atmosphere in the first processing unit 10 may be heated by a heat source such as an electric heating plate to heat the substrate 1. Examples of energy rays include infrared rays, far infrared rays, and microwaves. Since the heating unit 12 can efficiently heat the substrate 1, it is preferable that the heating unit 12 is configured to heat the substrate 1 by infrared irradiation. The first processing unit 10 preferably has a predetermined temperature distribution that monotonically increases from the first temperature T1 to the second temperature T2 over the first distance. In order to create a predetermined temperature distribution by infrared irradiation, a plurality of infrared irradiation devices can be provided, and the output of each infrared irradiation device can be gradually increased along the conveyance direction. In the invention, from the viewpoint of preventing wind prints and the like from being generated on the surface of the functional film, it is preferable not to perform heating by hot air drying. The arrangement position of the heating unit 12 in the first processing unit 10 is not limited, and may be arranged on the upper side of the substrate 1 to be conveyed, may be arranged on the lower side, or may be arranged on both sides.

Similar to the heating unit 12 in the first processing unit 10, the heating unit 22 in the second processing unit 20 heats the substrate 1 by irradiating energy rays and its radiant heat, the atmosphere in the second processing unit 20 may be heated by a heat source such as an electric heating plate to heat the substrate 1. The arrangement position of the heating unit 22 in the second processing unit 20 is not limited, and may be arranged on the upper side of the substrate 1 to be conveyed, may be arranged on the lower side, or may be arranged on both sides.

Examples of the method for satisfying the maximum value of the instantaneous temperature change rate of 5°C/sec or less in the first processing unit 10 include an adjusting method for the conveyance roll, an adjusting method for the surface temperature of the temperature control roll, and the like. As an adjusting method for the conveyance roll, at least one of the conveyance rolls may be a conveyance roll having a low heat transfer amount to the substrate 1 (hereinafter, also referred to as a "low heat transfer conveyance roll"). Examples of the low heat transfer conveyance roll include a surface stepped roll in which the contact area with the lower surface of the substrate 1 is reduced, a hollow roll having a small heat capacity, and the like. The low heat transfer conveyance roll preferably has an average heat capacity per width of 110 J/K or less, more preferably 80 J/K or less. The average heat capacity per width of the conveyance roll varies depending on the material of the conveyance roll, whether the conveyance roll is solid or hollow, the diameter of the conveyance roll, and the like. By using a hollow roll, a surface stepped roll, or the like, a conveyance roll having an average heat capacity of 110 J/K or less in the width direction can be constructed.

In the first processing unit 10, all the conveyance rolls (conveyance rolls 11a to 11f in Fig. 1) may be low heat transfer conveyance rolls, or only conveyance rolls arranged in a region where the instantaneous temperature change rate is likely to be high may be low heat transfer conveyance rolls. In the first processing unit 10, when the substrate 1 comes into contact with the conveyance roll in a state where the temperature of the substrate 1 is closer to the first temperature $T_1$ than the second temperature $T_2$, the instantaneous temperature change rate tends to increase, so that it is preferable that the conveyance rolls (the conveyance rolls 11a, 11b, and 11c in Fig. 1) arranged on the upstream side of the first distance d1 of the first processing unit 10 divided into two are low heat transfer conveyance rolls. Since the region where the instantaneous temperature change rate tends to be high is determined by the characteristics of a drying furnace, the instantaneous temperature change rate is calculated in advance, and the conveyance rolls arranged around the position where the instantaneous temperature change rate exceeds 5°C/sec are used may be adjusted by replacing with a low heat transfer conveyance roll.

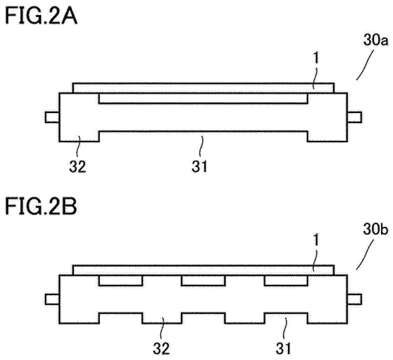

Figs. 2A and 2B are cross-sectional views schematically illustrating an example of a surface stepped roll. The surface stepped rolls 30a and 30b have a concave portion 31 and a convex portion 32 on the surface. In the concave portion 31, the lower surface of the substrate 1 does not come into contact with the roll to reduce the amount of heat transfer to the substrate 1. The surface stepped roll 30a has the convex portion 32 at an end, and the central region sandwiched between the convex portions 32 is the concave portion 31. The surface stepped roll 30b has the convex portion 32 at an end, and the concave portion 31 and the convex portion 32 are alternately formed in a central region sandwiched between the convex portions 32.

It is preferable that the lower surface of the region of the substrate 1 on which the coating film is provided faces the concave portion of the surface stepped roll. This is because it is possible to more effectively suppress the occurrence of streak-like unevenness that occurs in the coating film by reducing the amount of heat transfer particularly in the region where the coating film is provided in the substrate 1. By making the lower surface of a region of 50% or more, preferably 80% or more, and still more preferably 100% in the region where the coating film is provided, face the concave portion of the surface stepped roll, it is possible to greatly contribute to suppressing the occurrence of streak-like unevenness generated in the coating film by using the surface stepped roll.

In the first processing unit 10, in order to make the maximum value of the instantaneous temperature change rate satisfy 5°C/sec or less, as another adjusting method for the conveyance roll, a conveyance roll (hereinafter, also referred to as a "temperature control roll") capable of adjusting the surface temperature may be used for at least one of the conveyance rolls. The adjusting method for the surface temperature in the temperature control roll is not limited, and examples thereof include a passing method for a cooling fluid inside. The surface temperature of the temperature control roll is preferably the adjusted method so that the temperature difference from the temperature of the substrate at that position is equal to or less than a predetermined value. The predetermined value or less here is preferably 15°C or lower, more preferably 10°C or lower, and still more preferably 4°C or lower. A determination unit for determining the temperature difference between the surface temperature of the temperature control roll and the temperature of the substrate is provided. The surface temperature of the temperature control roll can be adjusted according to the determination result of the determination unit. In the first processing unit 10, when the substrate 1 comes into contact with the conveyance roll in a state where the temperature of the substrate 1 is closer to the first temperature $T_1$ than the second temperature $T_2$, the instantaneous temperature change rate tends to increase, so that it is preferable that the conveyance rolls (the conveyance rolls 11a, 11b, and 11c in Fig. 1) arranged on the upstream side of the first distance d1 of the first processing unit 10 divided into two are temperature control rolls. Since the region where the instantaneous temperature change rate tends to be high is determined by the characteristics of the drying furnace, the instantaneous temperature change rate is calculated in advance, and the conveyance rolls arranged around the position where the instantaneous temperature change rate exceeds 5°C/sec are used may be adjusted by replacing with a temperature control roll.

<Coating process>

In the coating process, ink is applied to the upper surface of the long substrate to form a coating film. The coating process may be a process performed while conveying the substrate or a process performed without conveying the substrate. It is preferable that the process is performed while conveying the substrate from the viewpoint that the above-mentioned drying process can be continuously performed after the coating process.

Examples of the ink coating method can include coating methods such as spin coating method, casting method, micro gravure coating method, gravure coating method, bar coating method, roll coating method, wire bar coating method, dip coating method, spray coating method, screen printing method, flexographic printing method, offset printing method, inkjet printing method, capillary coating method, nozzle coating method, and the like. The inkjet printing method which is an ejection type coating method is preferably used from the viewpoint of obtaining flatness of the coating film. The type of ink used in the coating process is not particularly limited, but the lower the ink concentration and the lower the viscosity of the ink, the more likely it is that streak-like unevenness will occur on the surface of the functional film. According to the invention, it is possible to suppress the occurrence of streak-like unevenness on the surface of the functional film even when low-concentration ink, low-viscosity ink, or the like is used.

In the coating process, ink is applied to an arbitrary region on the upper surface of the substrate according to the application of the functional film. It is preferable not to apply the coating composition to at least the end portion in the width direction of the long substrate so that the ink does not leak into the device.

<Manufacturing device>

One mode of the manufacturing device of the functional film according to the invention includes the above-mentioned drying device. According to this mode, it is possible to manufacture a functional film in which the occurrence of streak-like unevenness generated in a direction orthogonal to the conveyance direction in the drying device is suppressed.

[First embodiment]

Hereinafter, an embodiment of the invention will be described. This embodiment is a manufacturing method for an organic EL element having a functional film.

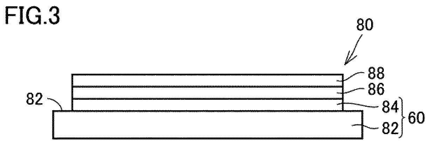

Fig. 3 is a cross-sectional view schematically illustrating the configuration of the organic EL element according to this embodiment. As illustrated in Fig. 3, an organic EL element 80 manufactured by the manufacturing method for an organic EL element according to this embodiment is, for example, an organic EL lighting panel used for lighting. The organic EL element 80 includes a substrate 82, an anode (first electrode) 84, a light-emitting layer (functional layer for organic EL) 86, and a cathode (second electrode) 88. The organic EL element 80 may take a form of emitting light from the anode 84 side or a form of emitting light from the cathode 88 side. Hereinafter, unless otherwise specified, the form emitting light from the anode 84 side will be described.

<Substrate>

The substrate 82 is transparent to visible light (light having a wavelength of 400 nm to 800 nm). The substrate 82 can be a film-like substrate. The thickness of the substrate 82 is, for example, 30 $\mu$m or more and 700 $\mu$m or less.

The substrate 82 has flexibility, and an example of the substrate 82 is a plastic film or a polymer film. Examples of the material of the substrate 82 include polyether sulfone (PES); polyester resin such as polyethylene terephthalate (PET) and polyethylene naphthalate (PEN); polyolefin resin such as polyethylene (PE), polypropylene (PP), and cyclic polyolefin; polyamide resins; polypropylene resins; polystyrene resins; polyvinyl alcohol resins; saponified products of ethylene-vinyl acetate copolymers; polyacrylonitrile resins; acetal resins; polyimide resins; epoxy resins, and the like.

A drive circuit (for example, a circuit including a thin film transistor or the like) for driving the organic EL element 80 may be formed on the substrate 82. Such drive circuits are usually formed of transparent material.

A barrier film may be formed on an upper surface 82a of the substrate 82. The barrier film can be, for example, a film made of silicon, oxygen, and carbon, or a film made of silicon, oxygen, carbon, and nitrogen. Specifically, examples of barrier film materials are silicon oxide, silicon nitride, silicon oxynitride, and the like. An example of the thickness of the barrier film is 100 nm or more and 10 $\mu$m or less.

<Anode>

The anode 84 is provided on the upper surface 82a of the substrate 82. An electrode exhibiting light transmittance is used for the anode 84. As the electrode exhibiting light transmittance, a thin film of a metal oxide, a metal sulfide, a metal or the like having high electric conductivity can be used, and a thin film having high light transmittance is preferably used. The anode 84 may have a network structure made of a conductor (for example, metal).

The thickness of the anode 84 can be determined in consideration of light transmittance, electrical conductivity, and the like. The thickness of the anode 84 is usually 10 nm to 10 $\mu$m, preferably 20 nm to 1 $\mu$m, and more preferably 50 nm to 500 nm. In the present specification, the substrate 82 provided with the anode 84 may be referred to as an electrode-mounted substrate 60.

<Light-emitting layer>

The light-emitting layer 86 is a functional film provided on the anode 84 and having a function of emitting light having a predetermined wavelength. The optimum value of the thickness of the light-emitting layer 86 differs depending on the material used, and is appropriately set so that the driving voltage and the luminous efficiency become appropriate values. The thickness of the light-emitting layer 86 is, for example, 1 nm to 1 $\mu$m, preferably 2 nm to 500 nm, and more preferably 10 nm to 200 nm.

<Cathode>

The cathode 88 is provided on the light-emitting layer 86. The optimum value of the thickness of the cathode 88 differs depending on the material used, and is set in consideration of electrical conductivity, durability, and the like. The thickness of the cathode 88 is usually 10 nm to 10 $\mu$m, preferably 20 nm to 1 $\mu$m, and more preferably 50 nm to 500 nm.

In the organic EL element 80, other functional films may be further provided between the anode 84 and the light-emitting layer 86, and between the light-emitting layer 86 and the cathode 88. An example of the layer configuration of the organic EL element 80 including various functional films is illustrated below.

 a) Anode/light-emitting layer/cathode
 b) Anode/hole injection layer/light-emitting layer/cathode
 c) Anode/hole injection layer/light-emitting layer/electron injection layer/cathode
 d) Anode/hole injection layer/light-emitting layer/electron transport layer/electron injection layer/cathode
 e) Anode/hole injection layer/hole transport layer/light-emitting layer/cathode
 f) Anode/hole injection layer/hole transport layer/light-emitting layer/electron injection layer/cathode
 g) Anode/hole injection layer/hole transport layer/light-emitting layer/electron transport layer/electron injection layer/cathode
 h) Anode/light-emitting layer/electron injection layer/cathode
 i) Anode/light-emitting layer/electron transport layer/electron injection layer/cathode

The symbol "/" means that the layers on both sides of the symbol "/" are joined together. The configuration in a) above corresponds to the configuration illustrated in Fig. 3.

The hole injection layer is a functional film having a function of improving the hole injection efficiency from the anode 84 to the light-emitting layer 86. The hole transport layer is a functional film having a function of improving the hole injection efficiency from the anode 84, the hole injection layer, or the hole transport layer closer to the anode 84 to the light-emitting layer 86. The electron transport layer is a functional film having a function of improving the electron injection efficiency from the cathode 88, the electron injection layer, or the electron transport layer closer to the cathode 88. The electron injection layer is a functional film having a function of improving the electron injection efficiency from the cathode 88 to the light-emitting layer 86. The electron injection layer may be a part of the cathode.

Known materials for each film can be used as the material of the functional film for organic EL such as the hole injection layer, the hole transport layer, the electron transport layer, and the electron injection layer. The optimum value of the thickness of each functional film for the organic EL differs depending on the material used, and is appropriately set so that the driving voltage and the luminous efficiency become appropriate values.

The organic EL element 80 may include a sealing portion that seals at least a functional film on the electrode-mounted substrate 60.

<Manufacturing method>

Next, an example of a manufacturing method for the organic EL element 80 having the configuration illustrated in Fig. 3 will be described. Hereinafter, a mode for manufacturing the organic EL element 80 by using the electrode-mounted substrate 60 in which the anode 84 is formed on the long substrate 82 having flexibility will be described. In the present specification, the long substrate and the long electrode-mounted substrate refer to a substrate and an electrode-mounted substrate having a length in the conveyance direction (X-axis direction), which will be described later, longer than the length in the width direction (Y-axis direction).

The long electrode-mounted substrate 60 can be produced by forming the anode 84 in each of a plurality of element forming regions set on the upper surface 82a of the long substrate 82 having flexibility.

Examples of the material of the anode 84 include indium oxide, zinc oxide, tin oxide, indium tin oxide (abbreviated as ITO), indium zinc oxide (abbreviated as IZO), gold, platinum, silver, and copper, and the like. Among these, ITO, IZO, or tin oxide is preferable. The anode 84 can be formed as a thin film of the exemplified material. As the material of the anode 84, an organic substance such as polyaniline and its derivative, polythiophene and its derivative may be used. In this case, the anode 84 can be formed as a transparent conductive film. As described above, the anode 84 may have a network structure made of a conductor (for example, metal).

The anode 84 can be formed by a method known in the manufacture of the organic EL element 80. Examples of the forming method for the anode 84 include a vacuum deposition method, a sputtering method, an ion plating method, a plating method, and a coating method.

Examples of the coating method include an inkjet printing method, but other known coating methods may be used as long as the anode 84 can be formed. Known coating methods other than the inkjet printing method include, for example, a slit coating method, a micro gravure coating method, a gravure coating method, a bar coating method, a roll coating method, a wire bar coating method, a spray coating method, a screen printing method, and a flexographic printing method, an offset printing method, a nozzle printing method, and the like.

The solvent of the coating liquid containing the material of the anode 84 may be any solvent that can dissolve the material of the anode 84. Examples of the solvent include chloride solvents such as chloroform, methylene chloride and dichloroethane, ether solvents such as tetrahydrofuran, aromatic hydrocarbon solvents such as toluene and xylene, ketone solvents such as acetone and methyl ethyl ketone, ester solvent such as ethyl acetate, butyl acetate, and ethyl cell soluble acetate.

The manufacturing method for the organic EL element 80 using the electrode-mounted substrate 60 includes a light-emitting layer forming process (functional film forming process) and a cathode forming process (electrode forming process). As described in this embodiment, in the embodiment in which the organic EL element 80 is manufactured from the long electrode-mounted substrate 60, normally, there is provided a cutting process in which the light-emitting layer 86 and the cathode 88 are formed in the long electrode-mounted substrate 60, and then the electrode-mounted substrate 60 is cut for every element forming region to get a plurality of organic EL elements 80. Therefore, a mode including a cutting process will be described.

<Light-emitting layer forming process>

In the light-emitting layer forming process, the light-emitting layer is formed by the above-mentioned manufacturing method for a functional film. In the light-emitting layer forming process, the light-emitting layer 86 is formed on the anode 84. The light-emitting layer forming process includes a coating process and a drying process.

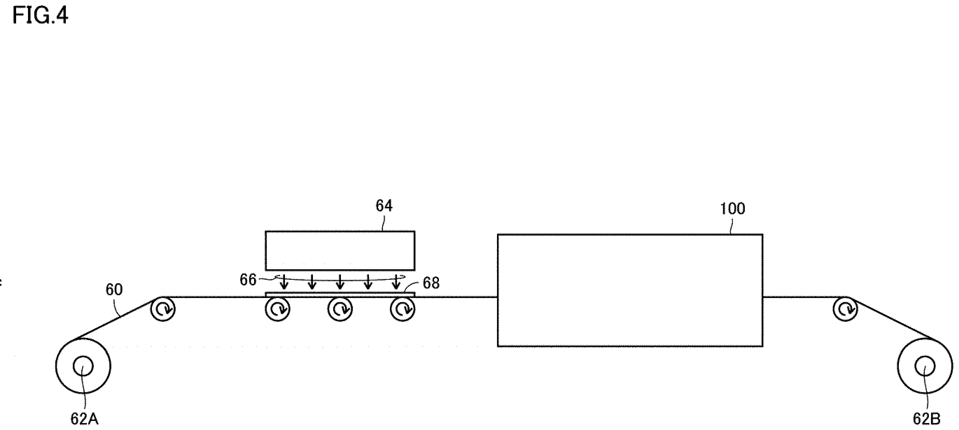

Fig. 4 is a cross-sectional view schematically illustrating the light-emitting layer forming process. In the light-emitting layer forming process, as illustrated in Fig. 4, the light-emitting layer 86 is formed by a roll-to-roll method. That is, the coating process and the drying process are performed sequentially after the long electrode-mounted substrate 60 wound around an unwinding roll 62A is unwound and conveyed in the longitudinal direction using a conveyance roller R and before being wound around a winding roll 62B.

(Coating process)

In the coating process, an ink 66 containing the material for the light-emitting layer 86 is coated on the anode 84 from an ink coater 64 arranged on the electrode-mounted substrate 60 to form a coating film 68. In this embodiment, the coating film 68 is formed by using an inkjet printing method. In this case, the ink coater 64 is an inkjet coater.

The ink coater 64, which is an inkjet coater, has a plurality of nozzle rows in the conveyance direction of the electrode-mounted substrate 60, and each nozzle row has a plurality of nozzles arranged in the width direction of the electrode-mounted substrate 60. The ink coater 64 may be, for example, a coater having a resolution of 600 dpi.

The material of the light-emitting layer 86 may be any known material for the light-emitting layer 86. The light-emitting layer 86 usually contains an organic substance that mainly emits fluorescence and/or phosphorescence, or a dopant that assists the organic substance. Dopants are added, for example, to improve luminous efficiency and change the emission wavelength. The organic substance contained in the light-emitting layer 86 may be a low molecular weight compound or a high molecular weight compound. Examples of the light emitting material forming the light-emitting layer 86 include the following dye-based materials, metal complex-based materials, organic substances that mainly contain polymer-based materials and the like and emit fluorescence and/or phosphorescence, and dopant materials.

Examples of the dye-based material include cyclopendamine or its derivative, tetraphenylbutadiene or its derivative, triphenylamine or its derivative, oxadiazole or its derivative, pyrazoloquinolin or its derivative, distyrylbenzene or its derivative, distyrylarylene or its derivative, pyrrole or its derivative, thiophene ring compound, pyridine ring compound, perinone or its derivative, perylene or its derivative, oligothiophene or its derivative, oxaziazole dimer or its derivative, pyrazoline dimer or its derivative, quinacridone or its derivative, and coumarin or its derivative.

Examples of the metal complex material include a metal complex which contains rare earth metals such as Tb, Eu, and Dy, or Al, Zn, Be, Pt, Ir, or the like as the central metal, and has a structure of oxadiazole, thiadiazole, phenylpyridine, phenylbenzimidazole, quinoline, or the like as a ligand. Examples of the metal complex include an iridium complex, a metal complex that emits light from a triplet excited state such as a platinum complex, an aluminum quinolinol complex, a benzoquinolinol berylium complex, a benzoxazolyl zinc complex, a benzothiazole zinc complex, an azomethyl zinc complex, a porphyrin zinc complex, and a phenanthroline europium complex.

Examples of the polymer-based material include polyparaphenylene vinylene or its derivative, polythiophene or its derivative, polyparaphenylene or its derivative, polysilane or its derivative, polyacetylene or its derivative, polyfluorene or its derivative, polyvinylcarbazole or its derivative, and materials obtained by polymerizing at least one of the above dye materials and metal complex materials.

Examples of the dopant material include perylene or its derivative, coumarin or its derivative, rubrene or its derivative, quinacridone or its derivative, squalium or its derivative, porphyrin or its derivative, styryl dye, tetracene or its derivative, pyrazolone or its derivative, decacyclene or its derivative, and phenoxazone or its derivative.

The solvent of the ink 66 is not limited as long as it can dissolve the material for the light-emitting layer 86. Examples of the solvent include chloride solvents such as chloroform, methylene chloride and dichloroethane, ether solvents such as tetrahydrofuran, aromatic hydrocarbon solvents such as toluene and xylene, ketone solvents such as acetone and methyl ethyl ketone, ester solvent such as ethyl acetate, butyl acetate, and ethyl cell soluble acetate.

In one embodiment, the viscosity of the ink 66 can be set so that the viscosity immediately after the ink 66 lands on the electrode-mounted substrate 60 is 1 mPa·s to 25 mPa·s. In one embodiment, the solid content concentration of the ink 66 may be set so that the solid content concentration immediately after the ink 66 lands on the electrode-mounted substrate 60 is 5% by weight or less.

(Drying process)

In the drying process, the coating film 68 is dried in the drying furnace of the drying device 100 to obtain the light-emitting layer 86. An example of the drying device 100 can be the drying device illustrated in Fig. 1. In the drying device 100, the first temperature $T_1$ is, for example, a temperature within the range of room temperature $\pm$ 10°C. The second temperature $T_2$ is preferably a temperature lower than the glass transition temperature of the resin constituting the long substrate to be conveyed, for example, a temperature in the range of 60°C or higher and 200°C or lower, and is preferably in the range of 80°C or higher and 120°C or lower.

(Cathode forming process)

In the cathode forming process, the cathode 88 is formed on the light-emitting layer 86. Since the light from the light-emitting layer 86 is reflected by the cathode 88 toward the anode 84, a material having a high visible light reflectance is preferable as the material of the cathode 88. Examples of the material of the cathode 88 include alkali metals, alkaline earth metals, transition metals, and Group 13 metals in the periodic table. As the cathode 88, a transparent conductive electrode made of a conductive metal oxide, a conductive organic substance, or the like may be used. The cathode 88 can be formed in the same manner as the forming method for the anode 84. The cathode 88 may be formed by a roll-to-roll method. That is, the cathode 88 may be formed on the light-emitting layer 86 while conveying the electrode-mounted substrate 60 in the longitudinal direction thereof.

(Cutting process)

In the cutting process, the long electrode-mounted substrate 60 on which the light-emitting layer 86 and the cathode 88 are formed is conveyed in the longitudinal direction thereof, and the electrode-mounted substrate 60 is cut for each element forming region. As a result, a plurality of organic EL elements 80 can be obtained from the long electrode-mounted substrate 60 on which the light-emitting layer 86 and the cathode 88 are formed.

[Examples]

Hereinafter, the invention will be described in more detail with reference to experimental examples, but the invention is not limited to these experimental examples.

<First to third experimental examples>

Functional films were prepared in the first to third experimental examples. In the first to third experimental examples, first, a long substrate (trade name: PEN-Q65H, 300 mm in width, 100 $\mu$m in thickness, manufactured by Teijin DuPont) was prepared, and this was applied while being conveyed at a conveyance speed of 2m/min so as to produce a functional film by performing a coating process and a drying process.

In the coating process, the ink was uniformly applied to the region of the upper surface of the substrate excluding the edge in the width direction using an inkjet coater.

In the drying process, the first process and the second process were performed using the drying device illustrated in Fig. 1. The first distance $d_1$ of the first processing unit was set to 2 m, the conveyance speed of the substrate 1 was set to 2 m/min, and the target reaching temperature in the first processing unit 10 was set to 90°C. In the first to third experimental examples, a functional film was produced under the conditions except that the six conveyance rolls used in the first processing unit were the rolls illustrated in Table 1 and their arrangement positions were the positions illustrated in Table 1 (positions 1 to 6). The arrangement positions illustrated in Table 1 are the positions when the position at the start of the first process (entrance of the first processing unit) is 0 m and the position at the end of the first process (exit of the first processing unit) is 2 m.

[Table 1]

| | CONVEYANCE ROLL | | | ARRANGEMENT POSITION (m) | | | | | |
|---|---|---|---|---|---|---|---|---|---|
| | TYPE | SURFACE MATERIAL | AVERAGE HEAT CAPACITY IN THE WIDTH DIRECTION | POSITION 1 | POSITION 2 | POSITION 3 | POSITION 4 | POSITION 5 | POSITION 6 |
| FIRST EXPERIMENTAL EXAMPLE | HOLLOW/ SURFACE SMOOTHING | POLYETHYLENE NAPHTHALATE | 60J/K | 0.15 | 0.45 | 0.75 | 1. 05 | 1.35 | 1. 65 |
| SECOND EXPERIMENTAL EXAMPLE | SOLID/ SURFACE STEPPED | POLYETHYLENE NAPHTHALATE | 60J/K | 0.15 | 0.45 | 0.75 | 1. 05 | 1.35 | 1. 65 |
| THIRD EXPERIMENTAL EXAMPLE | SOLID/ SURFACE SMOOTHING | CERAMIC | 6300J/K | 0.30 | 0.60 | 0.90 | 1.20 | 1.50 | 1. 80 |

In the first to third experimental examples, on the upper surface of the substrate, resistance temperature detectors were attached at a position 40 mm from one end in the width direction (referred to as "position A1") and a position 40 mm from the other end (referred to as "position A2") to measure the temperatures $T_x$ at position A1 and position A2 at 0.1 second intervals in the first process of the drying process. Both position A1 and position A2 corresponded to the region where the coating film was not provided on the upper surface of the substrate.

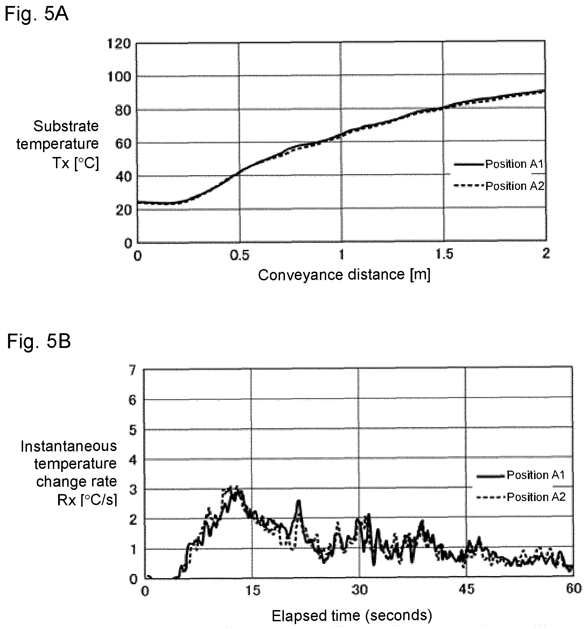

Fig. 5A is a graph in which, for the temperature $T_x$ in the first process of the first experimental example, the elapsed time x of the first process is converted into the conveyance distance from the start (0 m) of the first process using the conveyance speed, and plotted in the horizontal axis and connected in a straight line with the temperature $T_x$ on the vertical axis. Fig. 5B is a graph in which the instantaneous temperature change rate $R_x$ at the elapsed time x in the first process of the first experimental example is calculated according to the above method, and plotted in the vertical axis and connected in a straight line with the elapsed time x on the horizontal axis.

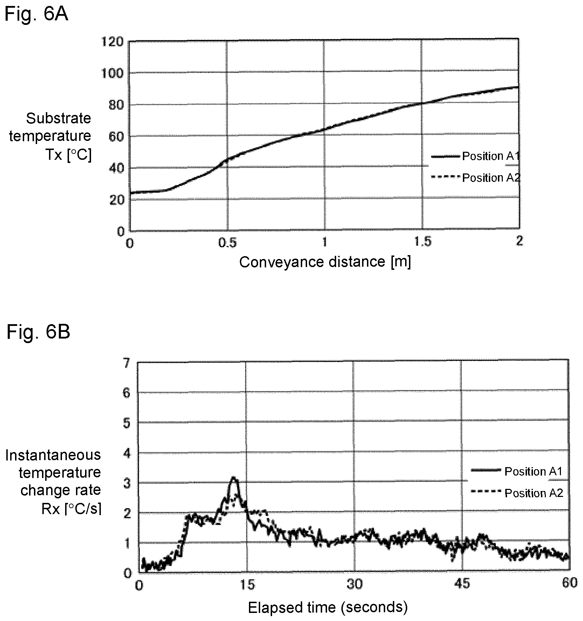

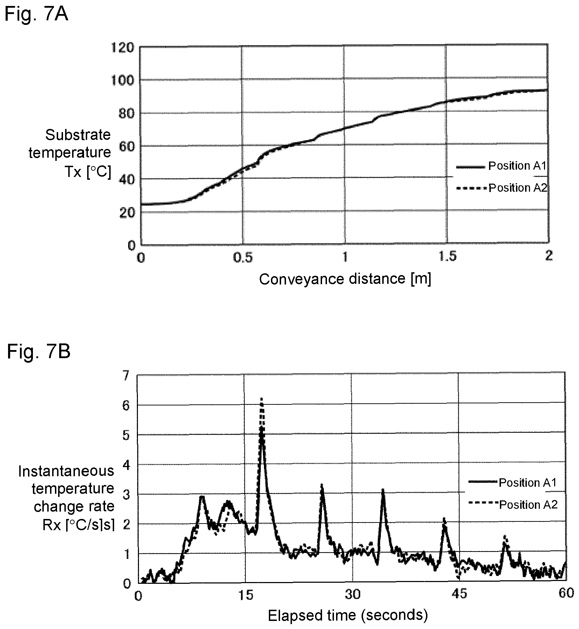

Figs. 6A and 6B are graphs created in the same manner as in Figs. 5A and 5B created by using the temperature $T_x$ of the first experimental example with respect to the temperature $T_x$ of the second experimental example. Figs. 7A and 7B are graphs created in the same manner as in Figs. 5A and 5B created by using the temperature $T_x$ of the first experimental example with respect to the temperature $T_x$ of the third experimental example.

Table 2 illustrates the maximum values of the first temperature $T_1$ (minimum temperature), the second temperature $T_2$ (maximum temperature), and the instantaneous temperature change rate $R_x$ in the first process of the drying process, which are extracted from the measurement results of the first to third experimental examples, and the calculated value of $(T_2-T_1)/d_1$.

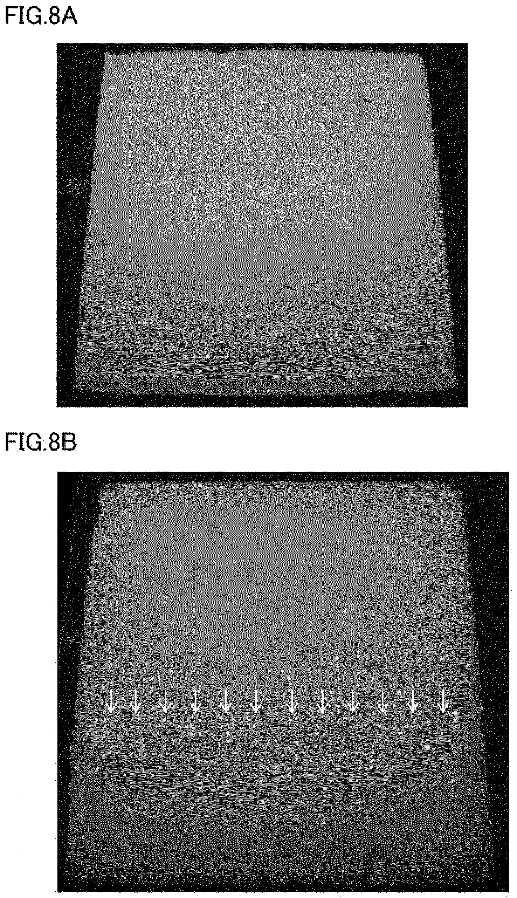

In the first to third experimental examples, the average thickness of the obtained functional film was about 0.1 $\mu$m. For each experimental example, a sample having a size of 150 mm $\times$ 150 mm was cut out from the obtained laminate of the functional film and the substrate, and the presence or absence of streak-like unevenness on the surface of the functional film was observed by a photoluminescence detector. Table 2 illustrates the observation results. Fig. 8A is a picture of the sample of the first experimental example taken by a photoluminescence imaging device. Fig. 8B is a picture of the sample of the third experimental example taken by a photoluminescence imaging device.

[Table 2]

| | FIRST TEMPERATURE $T_1$(°C) | SECOND TEMPERATURE $T_2$(°C) | MAXIMUM VALUE OF INSTANTANEOUS TEMPERATURE CHANGE RATE $R_X$ (°C/SEC) | $(T_2-T_1)$ /$d_1$ (°C/m) | PRESENCE/ ABSENCE OF STREAK-LIKE UNEVENNESS |
|---|---|---|---|---|---|
| FIRST EXPERIMENTAL EXAMPLE | 24.5 | 89.7 | 3.0 | 32.6 | ABSENT |
| SECOND EXPERIMENTAL EXAMPLE | 24.1 | 89.2 | 3.1 | 32.6 | ABSENT |
| THIRD EXPERIMENTAL EXAMPLE | 24.7 | 92.7 | 6.1 | 34 | PRESENT |

As can be seen from the observation results illustrated in Table 2 and Figs. 8A and 8B, in the first and second experimental examples in which the maximum value of the instantaneous temperature change rate $R_x$ is 5°C/s or less, no streak-like unevenness has been observed. On the other hand, in the third experimental example in which the maximum value of the instantaneous temperature change rate $R_x$ exceeds 5°C/s, streak-like unevenness (indicated by an arrow in Fig. 8B) in the direction orthogonal to the conveyance direction has been observed.

DESCRIPTION OF REFERENCE SIGNS

1... substrate
10... first processing unit

| | |
|---|---|
| 11a, 11b, 11c, 11d, 11e, 11f... | conveyance roll |
| 12... | heating unit |
| 20... | second processing unit |
| 21a, 21b, 21c, 21d, 21e, 21f... | conveyance roll |
| 22... | heating unit |
| 30a, 30b... | surface stepped roll |
| 31... | concave portion |
| 32... | convex portion |
| 60... | electrode-mounted substrate |
| 62A... | unwinding roll |
| 62B... | winding roll |
| 64... | ink coater |
| 66... | ink |
| 68... | coating film |
| 80... | organic EL element |
| 84... | anode |
| 86... | light-emitting layer |
| 100... | drying device |

**Claims**

1. A manufacturing method for a functional film provided on an upper surface of a long substrate, comprising:

coating an ink containing a material of the functional film on the upper surface of the substrate to form a coating film; and
drying the coating film while conveying the substrate,
wherein the drying process includes a first process in which the substrate is conveyed for a first distance and a temperature of the substrate is raised from a first temperature to a second temperature during conveyance,
in the first process, assuming that the first distance is $d_1$ (m), the first temperature is $T_1$ (°C), and the second temperature is $T_2$ (°C), the following expression is satisfied:

$$(T_2 - T_1)/d_1 \geq 10 \quad (1a),$$

and
a maximum value of an instantaneous temperature change rate of the substrate is 5°C/sec or less.

2. The manufacturing method for a functional film according to claim 1, wherein
the drying process includes a second process, after the first process, in which the substrate is conveyed by a second distance, and the temperature of the substrate is maintained in a range near the second temperature, and
the range near the second temperature is $T_2 \pm 5$°C.

3. The manufacturing method for a functional film according to claim 1 or 2, wherein, in the first process, two or more conveyance rolls are sequentially brought into contact with a lower surface of the substrate to convey the substrate.

4. The manufacturing method for a functional film according to claim 3, wherein at least one of the conveyance rolls is a hollow roll or a surface stepped roll.

5. The manufacturing method for a functional film according to claim 3 or 4, wherein at least one of the conveyance rolls has an average heat capacity of 110 J/K or less per width.

6. The manufacturing method for a functional film according to any one of claims 1 to 5, wherein, in the coating process, an ink is applied by an inkjet printing method.

7. The manufacturing method for a functional film according to any one of claims 1 to 6, wherein, in the first process, the substrate is heated by irradiation with infrared rays.

8. The manufacturing method for a coating film according to any one of claims 1 to 7, wherein the functional film is an element of an organic EL element.

9. A drying device for drying a coating film formed on an upper surface of a long substrate, comprising a first processing unit that conveys the substrate for a first distance and raises a temperature of the substrate from a first temperature to a second temperature during conveyance,

wherein, in the first processing unit, assuming that the first distance is $d_1$ (m), the first temperature is $T_1$ (°C), and the second temperature is $T_2$ (°C), the following expression is satisfied:

$$(T_2 - T_1)/d_1 \geq 10 \qquad (1a),$$

and
a maximum value of an instantaneous temperature change rate of 5°C/sec or less.

10. The drying device according to claim 9, further comprising a second processing unit, at a stage later than the first processing unit, that conveys the substrate for a second distance and maintains the temperature of the substrate in a range near the second temperature during conveyance,

wherein the range near the second temperature is $T_2 \pm 5$°C.

11. The drying device according to claim 9 or 10, wherein the first processing unit brings two or more conveyance rolls sequentially into contact with a lower surface of the substrate to convey the substrate.

12. The drying device according to claim 11, wherein at least one of the conveyance rolls is a hollow roll or a surface stepped roll.

13. The drying device according to claim 11 or 12, wherein at least one of the conveyance rolls has an average heat capacity of 110 J/K or less per width.

14. The drying device according to any one of claims 9 to 13, wherein the first processing unit heats the substrate by irradiation with infrared rays.

15. A manufacturing device for a functional film on an upper surface of a long substrate, comprising the drying device according to any one of claims 9 to 14.

16. The manufacturing device according to claim 15, wherein the functional film is an element of an organic EL element.

FIG.1

FIG.2A

1    30a

32    31

FIG.2B

1    30b

32    31

FIG.3

FIG.4

Fig. 5A

Fig. 5B

Fig. 6A

Fig. 6B

Fig. 7A

Fig. 7B

FIG.8A

FIG.8B

## INTERNATIONAL SEARCH REPORT

| International application No. |
| --- |
| PCT/JP2019/014664 |

### A. CLASSIFICATION OF SUBJECT MATTER
Int. Cl. B05D3/02(2006.01)i, B05C9/14(2006.01)i, B41F23/04(2006.01)i,
B41M7/00(2006.01)i, F26B3/30(2006.01)i, F26B13/10(2006.01)i,
F26B23/04(2006.01)i, H01L51/50(2006.01)i, H05B33/10(2006.01)i
According to International Patent Classification (IPC) or to both national classification and IPC

### B. FIELDS SEARCHED

Minimum documentation searched (classification system followed by classification symbols)
Int. Cl. B05D1/00-7/26, B05C7/00-21/00, B41F23/04, B41M7/00, F26B1/00-
25/22, H01L51/50, H05B33/10

Documentation searched other than minimum documentation to the extent that such documents are included in the fields searched
Published examined utility model applications of Japan      1922-1996
Published unexamined utility model applications of Japan    1971-2019
Registered utility model specifications of Japan            1996-2019
Published registered utility model applications of Japan    1994-2019

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | JP 2017-224573 A (SUMITOMO CHEMICAL CO., LTD.) 21 December 2017, claims, paragraphs [0007], [0024], [0061]-[0066], examples, 変形例, all drawings & WO 2017/217454 A1 & CN 109315044 A & KR 10-2019-0018476 A | 1, 3-4, 6-9, 11-12, 14-16 |
| X | JP 2003-126768 A (KONICA CORP.) 07 May 2003, claims, paragraphs [0001], [0010], examples, tables, all drawings (Family: none) | 1, 3-4, 6-9, 11-12, 14-16 |
| A | JP 2007-83228 A (FUJIFILM CORP.) 05 April 2007, entire text & US 2007/0048457 A1, entire document | 1-16 |

☒ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 07.06.2019 | 18.06.2019 |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

International application No.

PCT/JP2019/014664

C (Continuation). DOCUMENTS CONSIDERED TO BE RELEVANT

| Category* | Citation of document, with indication, where appropriate, of the relevant passages | Relevant to claim No. |
|---|---|---|
| A | WO 2016/208588 A1 (SUMITOMO CHEMICAL CO., LTD.) 29 December 2016, entire text & US 2018/0198095 A1 & EP 3313150 A1 & CN 107710875 A & KR 10-2018-0019147 A | 1-16 |
| A | JP 2005-224658 A (FUJI PHOTO FILM CO., LTD.) 25 August 2005, entire text (Family: none) | 1-16 |
| A | JP 2013-161589 A (KONICA MINOLTA, INC.) 19 August 2013, entire text (Family: none) | 1-16 |
| A | JP 2007-233375 A (FUJIFILM CORP.) 13 September 2007, entire text & US 2007/0177271 A1, entire document | 1-16 |
| A | JP 2017-37193 A (JX NIPPON OIL & ENERGY CORP.) 16 February 2017, entire text (Family: none) | 1-16 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002340479 A